# EUROPÄISCHE PATENTSCHRIFT

(11) **EP 1 282 921 B1**
(45) Veröffentlichungstag und Bekanntmachung des Hinweises auf die Patenterteilung: **09.08.2006**
(21) Anmeldenummer: 01943346.5
(22) Anmeldetag: 11.05.2001
(51) Int. Cl.: H01L 41/09

(54) **PIEZO-BIEGEWANDLER SOWIE VERWENDUNG DESSELBEN**
PIEZOELECTRIC BENDING TRANSDUCER AND USE THEREOF
TRANSDUCTEUR PIEZO A FLEXION ET SON UTILISATION

(30) Priorität: 15.05.2000 DE 10023556
(43) Veröffentlichungstag der Anmeldung: 12.02.2003
(73) Patentinhaber: FESTO AG & Co, 73734 Esslingen (DE)
(72) Erfinder: SCHMID, Andreas, 96247 Michelau (DE); RIEDEL, Michael, 96472 Rödental (DE); LUBITZ, Karl, 85521 Ottobrunn (DE); MAICHL, Martin, 73084 Salach (DE); HOFFMANN, Markus, 72649 Wolfschlugen (DE); WEINMANN, Michael, 73655 Plüderhausen (DE)
(74) Vertreter: Abel, Martin
(86) Internationale Anmeldenummer: PCT/EP2001/005395
(87) Internationale Veröffentlichungsnummer: WO 2001/089004

(56) Entgegenhaltungen:
- WO-A-89/07345
- WO-A-95/20827
- WO-A-99/13681
- US-A- 4 678 957
- PATENT ABSTRACTS OF JAPAN vol. 014, no. 458 (C-0766), 3. Oktober 1990 (1990-10-03) & JP 02 184378 A (TOSHIBA CORP), 18. Juli 1990 (1990-07-18)

## Beschreibung

Die Erfindung betrifft einen Piezo-Biegewandler, mit einem länglichen Tragkörper, der an wenigstens einer Längsseite mit einem mehrere Schichten aus Piezo-Material und dazwischenliegende Elektroden aufweisenden Piezo-Schichtkörper bestückt ist. Die Erfindung betrifft ferner die Verwendung eines derartigen Piezo-Biegewandlers.

Ein derartiger Piezo-Biegewandler, auch als Multilayer-Biegeaktor bezeichenbar, geht beispielsweise aus der WO 99/17383 hervor. Dieser verfügt über einen länglichen, platten- bzw. leistenförmigen Tragkörper, der an seinen beiden einander entgegengesetzten großflächigen Längsseiten jeweils mit einem Piezo-Schichtkörper bestückt ist. Jeder Piezo-Schichtkörper setzt sich aus mehreren aufeinanderliegenden Piezo-Materialschichten sowie zwischen den Piezo-Materialschichten angeordneten flächigen Elektroden zusammen. An die Elektroden kann über auf dem Tragkörper verlaufende elektrische Leiter eine Ansteuerspannung angelegt werden, die eine Längenkontraktion eines Piezo-Schichtkörpers hervorruft, woraus eine Auslenkung des Piezo-Biegewandlers senkrecht zur Längsrichtung resultiert.

Zur Betätigung des Piezo-Biegewandlers wird in aller Regel auf eine geeignete Elektronik zurückgegriffen, deren Komponenten beispielsweise dafür sorgen, eine zur Verfügung stehende Niedervoltspannung in eine ausreichende hohe Ansteuerspannung zu konvertieren. Dabei bietet die Multilayer-Technik den Vorteil, dass die für eine gewünschte Auslenkung des Piezo-Biegewandlers erforderliche elektrische Energie bereits bei einer wesentlich niedrigeren Ansteuerspannung zur Verfügung gestellt wird als bei einem vergleichbar dimensionierten monolithischen Piezo-Körper. Gleichwohl haben die Elektronikbauteile einen nicht geringen Platzbedarf, was die Miniaturisierung von mit dem Piezo-Biegewandler auszustattenden Einrichtungen, beispielsweise Ventile, behindert.

Einen weiteren Problempunkt bei den bekannten Piezo-Biegewandlern stellt die Überwachung und/oder Rückmeldung des Betriebsverhaltens dar. Die Installation einer hierfür erforderlichen Sensorik geht wiederum zu Lasten der Baugröße der mit dem Piezo-Biegewandler ausgestatteten Einrichtung.

Es ist daher eine Aufgabe der vorliegenden Erfindung, Maßnahmen anzugeben, die kompaktere Abmessungen von mit einem Piezo-Biegewandler der eingangs genannten Art ausgestatteten Einrichtungen ermöglichen. Eine weitere Aufgabe der Erfindung besteht in der Angabe einer vorteilhaften Verwendung für einen derartigen Piezo-Biegewandler.

Die erstgenannte Aufgabe wird im Zusammenhang mit einem Piezo-Biegewandler der eingangs genannten Art dadurch gelöst, dass im Innern des Tragkörpers und/oder zwischen dem Tragkörper und dem Piezo-Schichtkörper und/oder zwischen benachbarten Piezo-Materialschichten des Piezo-Schichtkörpers mindestens eine Komponente einer für den Betrieb des Piezo-Biegewandlers verwendeten Elektronik und/oder Sensorik untergebracht ist.

Der Erfindung liegt die Erkenntnis zugrunde, daß sich die im Zusammenhang mit einem Multilayer-Biegewandler einzusetzenden Komponenten der für den Betrieb erforderlichen Elektronik und/oder Sensorik in ihren Abmessungen und in ihrer Gestaltung so ausführen lassen, dass eine Integration in den Piezo-Biegewandler möglich ist und dementsprechend auf größeren Einbauraum beanspruchende externe Elektronik- und/oder Sensorikbauteile verzichtet werden kann. So können die Elektronik- und/oder Sensorikkomponenten beispielsweise im Innern des Tragkörpers untergebracht werden, lassen sich aber auch zwischen den Piezo-Materialschichten des Piezo-Schichtkörpers oder im Bereich zwischen dem Tragkörper und dem an diesen angesetzten Piezo-Schichtkörper plazieren. Im Zusammenhang mit den Sensorikkomponenten eröffnet dies auch die Möglichkeit, eine Plazierung praktisch unmittelbar dort vorzunehmen, wo eine betriebsrelevante Zustandsgröße erfaßt werden soll.

So kann zum Beispiel bei sicherheitskritischen Ventilanwendungen eine zuverlässige und präzise Rückmeldung der Aktorstellung durch in den Aufbau des Piezo-Biegewandlers integrierte Sensorikkomponenten gewährleistet werden.

Als besonders vorteilhaft hat es sich erwiesen, den Piezo-Biegewandler mit einem Piezo-Schichtkörper auszustatten, bei dem die Schichtdicke der einzelnen Piezo-Materialschichten maximal 25 µm beträgt, wobei ein Dickenbereich zwischen 14 µm und 20 µm empfehlenswert ist und vorzugsweise eine Schichtdicke von 17 µm gewählt wird. Es ergibt sich dadurch ein Niedervolt-Multilayer mit sehr dünnen Schichten und dementsprechend stark reduzierter Ansteuerspannung, die wesentlich geringer ist als die heute üblichen Ansteuerspannungen im Bereich oberhalb 60 Volt. Dementsprechend reduziert sich auch der Bauaufwand für zur Spannungskonvertierung notwendige elektronische Schaltungen, was die erfindungsgemäß vorgesehene Integration der Elektronikkomponenten in den Piezo-Biegewandler noch vereinfacht. Außerdem ergibt sich der Vorteil, daß für den Hochvoltbereich gültige Gestaltungsnormen nicht mehr relevant sind und sich somit vielfältigere Gestaltungsmöglichkeiten für die Leitungsführung und Gehäuseausführung des Piezo-Biegewandlers bzw. einer mit ihm ausgestatteten Einrichtung eröffnen. Gleichwohl wird eine ausreichende elektrische Feldstärke im Piezo-Material erreicht, und es sind, verglichen mit der Baugröße, große Stellkräfte und Stellwege möglich.

Vorteilhafte Weiterbildungen der Erfindung gehen aus den Unteransprüchen hervor.

Mindestens eine der integrierten Elektronikkomponenten kann zu einer Spannungswandlerschaltung, zu einer Strombegrenzungsschaltung oder zu einer Lade-/Entladeschaltung gehören bzw. unmittelbar eine solche bilden.

Mindestens eine Sensorikkomponente kann von einem zur Erfassung der Auslenkung des Biegewandlers dienenden Auslenkungssensor gebildet sein, beispielsweise in Gestalt von Dehnmeßstreifen(DMS), von einer oder mehreren Piezo-Materialschichten oder von induktiven Aufnehmern und Spulen. Ein großer Vorteil eines in das Trägermaterial oder in das Piezo-Material integrierten Auslenkungssensors ist die Möglichkeit zur Verwendung bei einer gezielten Nachsteuerung der Aktorauslenkung zur Kompensation der piezoelektrischen Relaxations- und Drifteffekte. Dies ermöglicht langzeitstabile gesteuerte Anwendungen. Eine weitere Möglichkeit zur Verwendung ist eine Funktionsüberwachung des Stellelements mittels Sensor.

Darüber hinaus können weitere Sensoren jeglicher Art und jeglichen Aufbaus nach Bedarf integriert sein, beispielsweise Kraft-, Beschleunigungs- oder Temperatursensoren.

Die Integration einer oder mehrerer Elektronik- und/oder Sensorikkomponenten in den Tragkörper läßt sich besonders einfach realisieren, wenn der Tragkörper als Mehrschichtkörper mit mindestens zwei aufeinanderliegenden Tragkörperschichten ausgebildet ist, wobei die Schichtebenen der Tragkörperschichten zweckmäßigerweise parallel zu denjenigen der Piezo-Materialschichten verlaufen und wobei sich die betreffenden Komponenten zwischen jeweils zwei benachbarten Tragkörperschichten plazieren lassen.

Um die zur Ansteuerung des Piezo-Schichtkörpers sowie für den Betrieb der eventuell vorhandenen Sensorik benötigten elektrischen Leiter in optimaler Verteilung am Tragkörper vorsehen zu können, sind die vorhandenen elektrischen Leiter zweckmäßigerweise in unterschiedlichen Bestückungsebenen des Tragkörpers angeordnet, wobei die gegenseitige Verbindung mittels einer oder mehrerer Durchkontaktierungen, sogenannter Vias, realisiert wird, die quer zu den Bestückungsebenen verlaufen. Bei einem in Multilayer-Technologie ausgeführten Tragkörper können elektrische Leiter sowohl zwischen benachbarten Tragkörperschichten als auch auf der Außenfläche der äußeren Tragkörperschichten vorgesehen sein, wobei beidseits einer Tragkörperschicht befindliche elektrische Leiter mittels Durchkontaktierungen kontaktiert sein können, die lediglich die betreffende Tragkörperschicht durchsetzen.

Dieser Aufbau bietet sich vor allem dann an, wenn der Piezo-Biegewandler über einen sogenannten Trimorph-Aufbau verfügt, wobei der Tragkörper mit zwei Piezo-Körpern bestückt ist, die an voneinander abgewandten Längsseiten des Tragkörpers angesetzt sind. Hier sind zweckmäßigerweise beide Piezo-Körper als Piezo-Schichtkörper der oben erläuterten Art ausgeführt, um auf Basis der geschilderten Vorteile eine erzwungene Auslenkung des Piezo-Biegewandlers in zwei einander entgegengesetzten Richtungen zu ermöglichen. Man kann eine Ausführung vorsehen, bei der der Trimorph-Biegewandler über eine Faserverbund-Mittellage verfügt, in Verbindung mit flexiblen Leiterbahnschichten als Kontaktzuführung zu den aktiven Piezo-Materialschichten, zur Sensorik und/oder zur Elektronik. Durch eine geeignete Auswahl von Materialien mit entsprechenden thermischen Ausdehnungskoeffizienten ist eine gezielte Reduzierung der thermischen Drifts realisierbar. Ein Beispiel hierfür ist die gezielte Einbringung von Kupferschichten in den Aktuatorgesamtaufbau. Die Kupferschichten können neben der Reduzierung der thermischen Drifts auch zur Einstellung der gezielten mechanischen Eigenschaften wie Auslenkung und Stellkraft sowie zur Kontaktierung der aktiven Piezo-Materialschichten, der integrierten Sensoren und/oder der Elektronik verwendet werden.

Anstelle eines zweiten aktiven Piezo-Körpers kann vorteilhafterweise auch ein Anpaßkörper vorgesehen sein, der aus einem Material mit im wesentlichen gleichen thermischen Ausdehnungskoeffizienten besteht wie das Piezo-Material des Piezo-Schichtkörpers. Dieser Anpaßkörper trägt zur Erzeugung von Auslenkkräften nicht bei, ist also ein passives Element, bewirkt jedoch, dass im Vergleich zu einem nur einseitig mit einem Piezo-Körper bestückten Piezo-Biegewandler - einer sogenannten Unimorph-Bauart - mit relativ geringen Kosten ein symmetrischer Aufbau erzielt werden kann, so dass die thermische Eigenverbiegung reduziert oder gar vollständig ausgeschlossen werden kann. Darüber hinaus kann das Anpaßmaterial selbst Sensor sein oder in diesem integriert sein. Der Sensor kann auch in das Anpaßteil integriert sein.

Die eingangs genannte, auf eine besondere Verwendung abzielende zweite Aufgabe der Erfindung wird dadurch gelöst, daß der Piezo-Biegewandler als Stellglied eines Ventils eingesetzt wird, insbesondere auf dem Pneumatiksektor zur Steuerung von Luftströmungen.

Nachfolgend wird die Erfindung anhand der beiliegenden Zeichnung näher erläutert. Es zeigen im einzelnen:
- Fig. 1: eine bevorzugte Ausführungsform des erfindungs-gemäßen Piezo-Biegewandlers in stark vergrößerter, perspektivischer Darstellung und teilweise explodiert,
- Fig. 2: eine Draufsicht auf die in Fig. 1 nach oben weisende Tragfläche des Tragkörpers mit Blick gemäß Pfeil II,
- Fig. 3: einen Längsschnitt durch den Tragkörper aus Fig. 1 gemäß Schnittlinie III-III mit Blick auf die nach oben weisende Fläche der unteren Tragkörperschicht,
- Fig. 4: einen Längsschnitt durch den Tragkörper aus Fig. 1 gemäß Schnittlinie IV-IV, wobei strichpunktiert an der nach unten weisenden Tragfläche optional vorhandene elektrische Leiter angedeutet sind,
- Fig. 5: den Piezo-Biegewandler aus Fig. 1 bis 4 im Querschnitt gemäß Schnittlinie V-V aus Fig. 1 und 2, unter Andeutung einer vorteilhaften Verwendung im Zusammenhang mit einem Steuerventil auf dem Sektor der Pneumatik,
- Fig. 6 und 7: entsprechend den Fig. 2 und 3 geführte Längsschnitte durch einen Tragkörper eines weiteren Ausführungsbeispiels des Piezo-Biegewandlers,
- Fig. 8: einen Ausschnitt eines weiteren Ausführungs-beispiels des Piezo-Biegewandlers im Längsschnitt gemäß Schnittlinie VIII-VIII aus Fig. 9 und
- Fig. 9: eine Draufsicht auf die nach oben orientierte Tragfläche des Tragkörpers gemäß Fig. 8 ohne Darstellung des darauf sitzenden Piezo-Körpers.

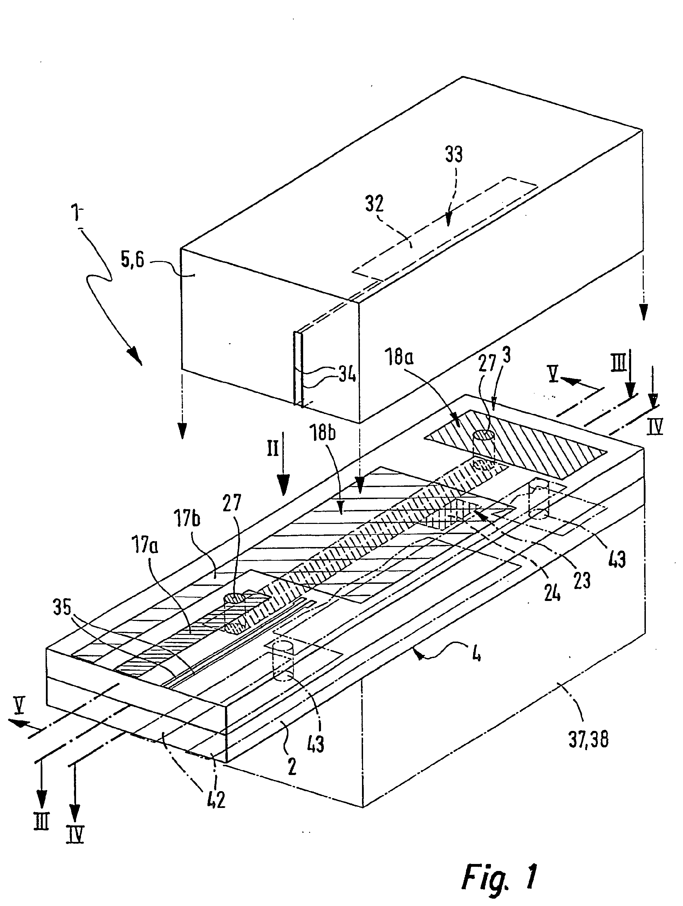

Der in Fig. 1 bis 5 dargestellte Piezo-Biegewandler 1 verfügt über einen länglichen, platten- oder leistenartig ausgeführten Tragkörper 2, der eine gewisse Steifigkeit besitzt, gleichwohl jedoch biegbar ist und bevorzugt aus einem Faserverbundmaterial oder aus mehrschichtigen Kunststofflagen vorzugsweise aus Polymid besteht.

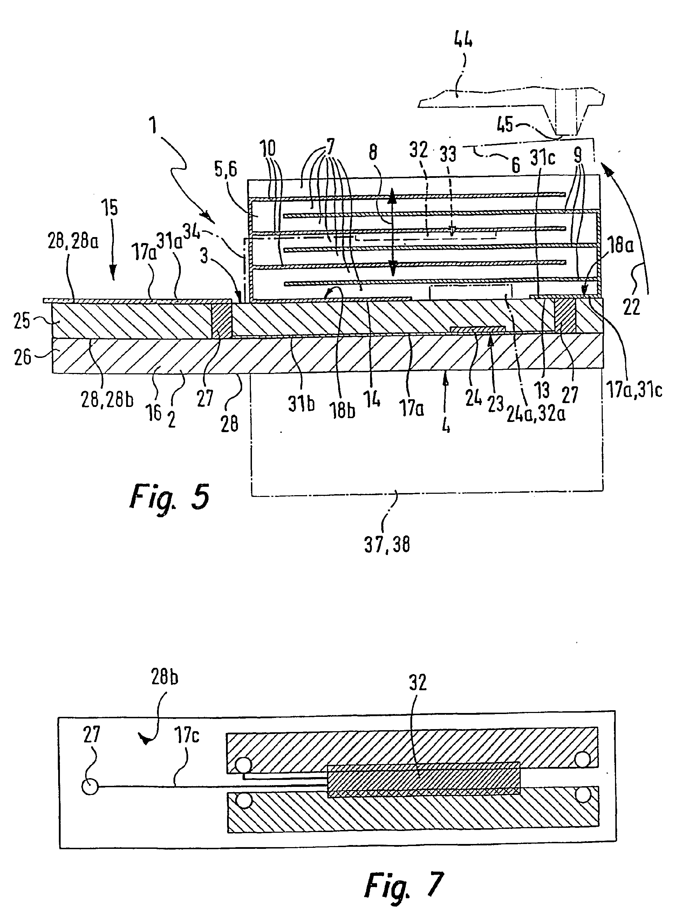

Die sich an einander entgegengesetzten Längsseiten befindenden, voneinander abgewandten großflächigen Außenflächen des Tragkörpers 2 bilden eine in Fig. 1 und 5 exemplarisch nach oben orientierte erste Tragfläche 3 sowie eine nach unten weisende zweite Tragfläche 4. Auf die eine, erste Tragfläche 3 ist ein erster Piezo-Körper 5 aufgebracht, der in Multi-layer-Technologie ausgeführt ist, so daß es sich um einen Piezo-Schichtkörper 6 handelt. Er enthält, wie die Fig. 5 verdeutlicht, eine Mehrzahl ebener Piezo-Materialschichten 7, die in einer durch Doppelpfeil 8 angedeuteten, rechtwinkelig zur ersten Tragfläche 3 orientierten Stapelrichtung 8 mit zueinander parallelen Schichtebenen aufeinandergestapelt sind. Als Piezo-Material kann jeder piezo-elektrische Werkstoff verwendet werden, vorzugsweise eine Piezo-Keramik.

Die Schichtebenen der Piezo-Materialschichten 7 verlaufen parallel zur Ausdehnungsebene des Tragkörpers 2.

Zwischen jeweils benachbarten Piezo-Materialschichten 7 erstreckt sich eine dünne Elektrode 9, 10 mit flächenhafter Ausdehnung, vorzugsweise in Gestalt einer Silber-/Palladium-Metallisierungsschicht. Dabei sind in der Stapelrichtung 8 abwechselnd erste (9) und zweite (10) Elektroden vorgesehen, so dass jede Piezo-Materialschicht 7 - beim Ausführungsbeispiel mit Ausnahme der untersten und der obersten Piezo-Materialschicht 7 - auf entgegengesetzten Seiten von einer ersten und zweiten Elektrode 9, 10 flankiert ist. Dabei sind sowohl die ersten Elektroden 9 als auch die zweiten Elektroden 10 untereinander elektrisch verbunden und mit einer ersten bzw. zweiten Kontaktierungsfläche 13, 14 verschaltet, die an der Unterseite der sich unmittelbar an den Tragkörper 2 anschließenden untersten Piezo-Materialschicht 7 vorgesehen ist.

Die oberste Piezo-Materialschicht 7 kann wie abgebildet eine inaktive Deckschicht sein, es wäre jedoch ohne weiteres möglich, an ihrer Oberseite ebenfalls eine Elektrode vorzusehen, um sie aktiv zu nutzen.

Die an den Außenflächen des Piezo-Schichtkörpers 6 verlaufenden, zur Kontaktierung der Elektroden 9, 10 dienenden leitfähigen Schichten sind zweckmäßigerweise mit einer nicht näher dargestellten Vergußmasse aus Epoxidharz versiegelt.

Der Piezo-Schichtkörper 6 belegt nur einen Teil der Baulänge der ersten Tragfläche 3. Daher ragt der Tragkörper 2 an einer Anschlußseite 15 des Piezo-Biegewandlers 1 mit einem Anschlußabschnitt 16 über den Piezo-Schichtkörper 6 hinaus. Über den Anschlußabschnitt 16 werden die für den Betrieb des Piezo-Biegewandlers 1 erforderlichen elektrischen Anschlüsse vorgenommen und kann auch die Einspannung des Piezo-Biegewandlers erfolgen.

Zur Ansteuerung des Piezo-Schichtkörpers 6 ist der Tragkörper 2 mit beispielsweise von Leiterbahnen, von Metallisierungen und/oder von leitfähigen Kunststoffschichten gebildeten ersten und zweiten elektrischen Leitern 17a, 17b ausgestattet. Sie verlaufen ausgehend vom freien stirnseitigen Ende des Anschlußabschnittes 16 bis in den vom Piezo-Schichtkörper 6 überdeckten Tragkörperabschnitt, wo sie als erste und zweite elektrische Verbindungsflächen 18a, 18b ausgeführt sind, die mit den ersten und zweiten Kontaktierungsflächen 13, 14 des Piezo-Schichtkörpers 6 elektrisch kontaktiert sind.

Somit läßt sich der Piezo-Schichtkörper 6 über die ersten und zweiten elektrischen Leiter 17a, 17b mit einer Ansteuerspannung beaufschlagen, die in an sich bekannter Weise eine Längenänderung der Piezo-Materialschichten 7 hervorruft, was bei im Bereich des Anschlußabschnittes 16 eingespanntem Piezo-Biegewandler 1 eine Krümmung sowie eine damit verbundene Auslenkung senkrecht zur Längsrichtung des Biegewandlers gemäß Pfeil 22 des uneingespannten vorderen Endbereiches des Piezo-Biegewandlers 1 hervorruft.

Zwar kann der Anschlußabschnitt 16 vorteilhaft zum Einspannen des Piezo-Biegewandlers 1 herangezogen werden. Es ist allerdings auch ohne weiteres möglich, die Einspannung in dem sich an den Anschlußabschnitt 16 anschließenden Bereich des Piezo-Schichtkörpers 6 vorzunehmen.

Zur Reduktion der Ansteuerspannung sind die Piezo-Materialschichten 7 sehr dünn ausgeführt. Die Schichtdicke beträgt beim Ausführungsbeispiel 17 µm, wobei der insgesamt empfehlenswerte Dickenbereich zwischen 14 µm und 20 µm liegt und zweckmäßigerweise 25 µm nicht überschreitet. Durch die dadurch mögliche Niedervoltansteuerung mit Ansteuerspannungen bis maximal 60 Volt und vorzugsweise einer noch um einiges unter diesem Maximalwert liegenden Ansteuerspannung sind gewisse, bei Hochspannungsanwendungen geltende Vorschriften nicht mehr zutreffend, und es bestehen flexiblere Möglichkeiten für eine günstige Anordnung der elektrischen Leiter.

Die Ausbildung des Piezo-Schichtkörpers 6 als Niedervolt-Multilayer mit sehr dünnen Schichten und daraus resultierenden geringen Ansteuerspannungen hat den weiteren Vorteil, dass die für den Betrieb des Piezo-Biegewandlers 1 eingesetzte Elektronik 23 über einen verglichen mit konventionellen Bauformen wesentlich einfacheren, platzsparenderen und kostengünstigeren Aufbau verfügen kann.

Die geringe Baugröße der Elektronik 23 wird nun bei dem Piezo-Biegewandler 1 ausgenutzt, um mindestens eine Elektronikkomponente 24 und vorzugsweise sämtliche Elektronikkomponenten bzw. die gesamte Ansteuerelektronik in den Piezo-Biegewandler 1 zu integrieren. Beim Ausführungsbeispiel der Fig. 1 bis 5 ist die mindestens eine Elektronikkomponente 24 gut geschützt im Innern des Tragkörpers 2 untergebracht, der hierbei als Mehrschichtkörper ausgeführt ist und über zwei flächig aufeinanderliegende Tragkörperschichten 25, 26 verfügt, zwischen denen die mindestens eine Elektronikkomponente 24 plaziert ist. Bei einem mehr als zwei Tragkörperschichten aufweisenden Tragkörper 2 könnten in entsprechender Weise die weiteren Schichtübergangsbereiche zur Unterbringung einer oder mehrerer Elektronikkomponenten verwendet werden.

Um die dementsprechend integrierte Elektronikkomponente 24 in der gewünschten Weise zu kontaktieren, wird auf im Tragkörper 2 geeignet plazierte Durchkontaktierungen 27, sogenannte Vias, zurückgegriffen. Mit solchen Durchkontaktierungen 27 lassen sich unterschiedliche, jeweils mit elektrischen Leitern bestückte Bestückungsebenen 28 erschließen und die entsprechenden elektrischen Leiter elektrisch miteinander kontaktieren. Die Anzahl der Durchkontaktierungen 27 ist dabei prinzipiell beliebig und orientiert sich am gewünschten Schaltungs-Layout.

Beim Ausführungsbeispiel der Fig. 1 bis 5 verläuft der zweite elektrische Leiter 17b auf der ersten Tragfläche 3, die hier hinsichtlich der elektrischen Leiter eine erste Bestückungsebene 28a repräsentiert. Der zweite elektrische Leiter 17b verläuft dabei in seiner Gesamtheit in der ersten Bestückungsebene 28a.

Der erste elektrische Leiter 17a hingegen ist in mehrere Leiterabschnitte unterteilt, die in verschiedenen Bestückungsebenen verlaufen und mittels Durchkontaktierungen 27 miteinander verknüpft sind. So erstreckt sich ein erster Leiterabschnitt 31a im Bereich des Anschlußabschnittes 16 auf der ersten Tragfläche 3 und der von dieser definierten ersten Bestückungsebene 28a. Noch vor Erreichen des Piezo-Schichtkörpers 6 ist eine lediglich die die erste Tragfläche 3 aufweisende erste Tragkörperschicht 25 durchsetzende Durchkontaktierung 27 vorgesehen, die zu einer zweiten Bestückungsebene 28b führt, welche vom Übergangsbereich zwischen den beiden Tragkörperschichten 25, 26 gebildet ist. Dort schließt sich ein zweiter Leiterabschnitt 31b des ersten elektrischen Leiters 17a an, der im Innern des Tragkörpers 2 unterhalb des Piezo-Schichtkörpers 6 verläuft und dabei die zweite elektrische Verbindungsfläche 18b unterhalb passiert. Auf Höhe der ersten elektrischen Verbindungsfläche 18a ist der zweite Leiterabschnitt 31b mit einer weiteren Durchkontaktierung 27 kontaktiert, die die erste Tragkörperschicht 25 erneut durchsetzt und mit dem die erste elektrische Verbindungsfläche 18a definierenden dritten Leiterabschnitt 31c verbunden ist, der sich nun wiederum in der ersten Bestückungsebene 28a befindet.

Die mindestens eine Elektronikkomponente 24 ist in der zweiten Bestückungsebene 28b plaziert und mit dem dort verlaufenden zweiten Leiterabschnitt 31b in gewünschter Weise verschaltet.

Im Falle des beim Ausführungsbeispiel gezeigten Zweischicht-Tragkörpers 2 könnten auch Durchkontaktierungen vorgesehen sein, die sich durch beide Tragkörperschichten 25, 26 gleichzeitig hindurcherstrecken. Auch besteht die Möglichkeit, voneinander getrennte Durchkontaktierungen in sämtlichen Tragkörperschichten vorzusehen, um beidseits derselben vorhandene elektrische Leiter und/oder Elektronikkomponenten elektrisch zu verknüpfen.

Die mindestens eine Elektronikkomponente 24 kann zu einer Ansteuerelektronik für den Piezo-Biegewandler 1 gehören oder eine solche bilden. Die Elektronik kann insbesondere eine Spannungswandlerschaltung zur Konvertierung der angelegten Eingangsspannung auf die gewünschte Ansteuerspannung enthalten. Von Vorteil ist auch eine Strombegrenzungsschaltung, die Beschädigungen der Piezo-Charakteristik durch Überbeanspruchung verhindert. Eine Lade-/Entladeschaltung, die bei einem Zweidrahtbetrieb die zum Rückstellen der Auslenkung erforderliche Entladung ermöglicht, ist ebenfalls von Vorteil.

Es versteht sich, dass diese Aufzählung rein exemplarischen und nicht abschließenden Charakter hat.

Der Piezo-Biegewandler 1 des Ausführungsbeispiels zeichnet sich ferner dadurch aus, dass in ihn, zusätzlich zu mindestens einer Elektronikkomponente, auch mindestens eine in Fig. 1 und 5 gestrichelt angedeutete Sensorikkomponente 32 einer für den Betrieb des Piezo-Biegewandlers verwendeten Sensorik 33 integriert ist.

Die mindestens eine Sensorikkomponente 32 ist beim Ausführungsbeispiel im Innern des Piezo-Schichtkörpers 6 zwischen zwei benachbarten Piezo-Materialschichten 7 untergebracht. Sie kann dort bei der Herstellung des Piezo-Schichtkörpers 6 bequem plaziert werden. Für ihren Betrieb erforderliche elektrische Kontaktmittel 34 können beispielsweise zu einer Stirnseite des Piezo-Schichtkörpers 6 und von dort zur Unterseite desselben geführt werden, so dass sie bei am Tragkörper 2 fixiertem Piezo-Schichtkörper 6 mit weiteren elektrischen Leitern 35 kontaktiert werden, die auf der ersten Tragfläche 3 im Bereich des Anschlußabschnittes 16 vorgesehen sind.

Durch die Plazierung mindestens einer Sensorikkomponente 32 und zweckmäßigerweise der gesamten Sensorik 33 im Innern des Piezo-Biegewandlers 1 können die interessierenden Größen unmittelbar an der relevanten Stelle erfaßt werden. Außerdem erübrigt sich eine zusätzlichen Platz beanspruchende Installation an der Außenfläche des Piezo-Biegewandlers oder an einem im späteren Einsatz den Piezo-Biegewandler 1 enthaltenden Gehäuse. Dies gilt im übrigen auch für die integrierte mindestens eine Elektronikkomponente 24 bzw. Elektronik 23. Durch die Unterbringung im Innern des Piezo-Biegewandlers 1 kann auch auf zusätzliche Schutzmaßnahmen verzichtet werden, da die Komponenten durch die sie umgebenden Bestandteile des Piezo-Biegewandlers 1 vor äußeren Einflüssen geschützt nach außen hin abgeschirmt sind.

Mindestens eine Sensorikkomponente 32 kann auch in der anhand der Elektronikkomponente 24 beschriebenen Weise in den Tragkörper 2 integriert sein, wie auch mindestens eine Elektronikkomponente im Innern des Piezo-Schichtkörpers 6 plaziert sein kann. Ein weiterer vorteilhafter Ort zur Unterbringung einer Elektronik- und/oder Sensorikkomponente ist der Bereich zwischen dem Tragkörper 2 und dem daran fixierten Piezo-Schichtkörper 6, wobei in Fig. 5 eine entsprechende Elektronik- und/oder Sensorikkomponente strichpunktiert bei 24a, 32a angedeutet ist.

Es versteht sich, dass ein und derselbe Piezo-Biegewandler 1 je nach Anwendungsfall lediglich mit Elektronikkomponenten oder lediglich mit Sensorikkomponenten oder gleichzeitig mit Komponenten sowohl einer Elektronik als auch einer Sensorik ausgestattet sein kann. Dabei ist der Ort der Unterbringung jeweils beliebig auswählbar.

Eine im Piezo-Biegewandler 1 integrierte Sensorik kann als Sensorikkomponente insbesondere einen Auslenkungssensor beinhalten, beispielsweise einen Dehnmeßstreifen oder sonstige Aufnehmer und Spulen, anhand derer sich Rückschlüsse auf die momentane Auslenkung des Piezo-Biegewandlers 1 ziehen lassen.

Die Fig. 6 und 7 zeigen eine Möglichkeit zur Integration einer beispielhaft als Dehnmeßstreifen ausgebildeten Sensorikkomponente 32 in den Tragkörper 2. Dabei ist ersichtlich, dass zusätzlich zu den erläuterten ersten und zweiten elektrischen Leitern 17a, 17b weitere, dritte elektrische Leiter 17c zur Kontaktierung der Sensorikkomponenten 32 vorgesehen sein können, die in der ersten und zweiten Bestückungsebene 28a, 28b verlaufen und mittels Durchkontaktierungen 27a verknüpft sein können.

Weitere empfehlenswerte Sensorikkomponenten sind Kraftsensoren, Beschleunigungssensoren und Temperatursensoren, die für eine optimal überwachte Betätigung des Piezo-Biegewandlers herangezogen werden können.

Um den Schichtaufbau des Piezo-Schichtkörpers 6 und/oder des Tragkörpers 2 nicht nennenswert zu beeinträchtigen - die Schichtebenen der Tragkörperschichten verlaufen parallel zu denjenigen der Piezo-Materialschichten -, wird für die integrierten Elektronik- und/oder Sensorikkomponenten 24, 32 auf extrem dünn ausführbare Bauarten zurückgegriffen, die kaum auftragen. Derartige Bauformen lassen sich in sogenannter Dünnschichttechnik bzw. als SMD-Bauelemente (SMD = Surface Mounted Device) oder als Nackt-Chips, also als ungekapselte Halbleiterchips ausführen. Da die zur Unterbringung der Komponenten vorhandene Schichtfläche sehr groß ist, kann das Schaltungs-Layout der Komponenten zugunsten einer geringen Bauhöhe umfangreich in die Länge und Breite verlagert werden.

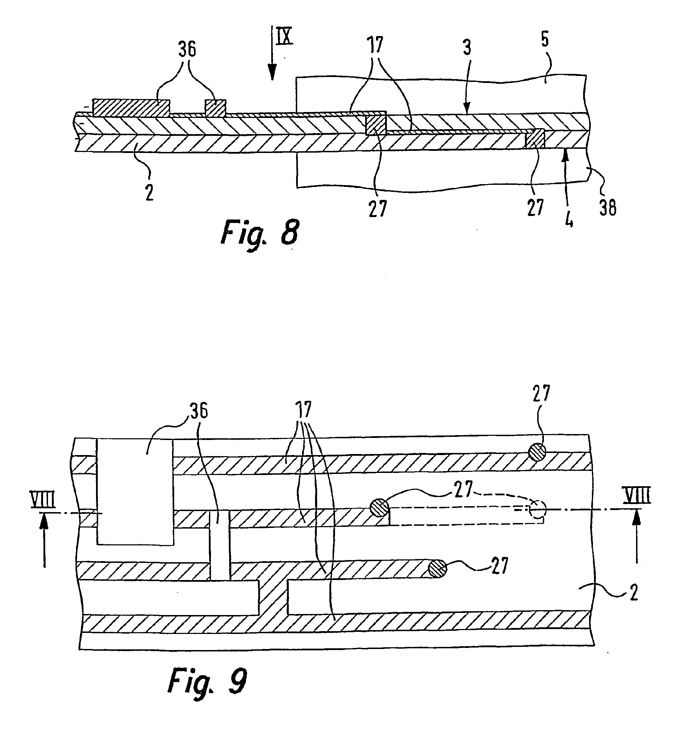

Die Fig. 8 und 9 zeigen alternative Ausführungsformen eines Tragkörpers 2, wobei ersichtlich ist, dass zusätzliche Elektronik- und/oder Sensorikkomponenten 36 vorhanden sein können, die sich in einem nicht von einem Piezo-Körper belegten Außenflächenabschnitt des Tragkörpers 2 befinden. Sie können insbesondere an dem auf dem Anschlußabschnitt 16 verlaufenden freien Flächenabschnitt einer Tragfläche 3 angeordnet sein.

Die Fig. 8 und 9 machen im übrigen auch deutlich, dass elektrische Leiter 17 und Durchkontaktierungen 27 nach Bedarf in praktisch beliebiger geeigneter Verteilung am Tragkörper 2 vorgesehen werden können.

Bei den Durchkontaktierungen 27 handelt es sich um elektrisch leitfähige Materialien, die in den Tragkörper 2 quer zu seiner Ausdehnungsebene ganz oder teilweise durchsetzende Ausnehmungen oder Durchbrechungen eingebracht sind. Als Material kann beispielsweise ein Leitkleber verwendet werden.

Der bisher beschriebene Piezo-Biegewandler 1 kann als Unimorph-Biegewandler bezeichnet werden. Auf Grund seines unsymmetrischen Aufbaus treten bei einem solchen Unimorph-Biegewandler allerdings relativ hohe thermische Eigenverbiegungen auf, die das Betriebsverhalten beeinträchtigen können. Durch die integrierte Sensorik lassen sich piezo-elektrische Relaxations- und Drifteffekte allerdings gezielt kompensieren, so dass mit der erfindungsgemäßen Integration das Betriebsverhalten eines Unimorph-Biegewandlers relativ einfach optimiert werden kann. Des weiteren kann durch die im Trägerkörper integrierten Materialien der Arbeitspunkt des Biegewandlers gezielt beeinflusst werden.

Eine weitere Möglichkeit zur kostengünstigen Reduktion der thermischen Eigenverbiegung besteht darin, den Piezo-Biegewandler in Trimorph-Technologie aufzubauen und auf der zweiten Tragfläche 4, auf gleicher Höhe wie der Piezo-Schichtkörper 6, einen als Anpaßkörper 37 bezeichenbaren Körper vorzusehen, der aus einem Material besteht, das im wesentlichen die gleichen thermischen Ausdehnungskoeffizienten wie der Piezo-Schichtkörper 6 aufweist. Dabei bietet es sich an, als Anpaßkörper 37 einen zweiten Piezo-Körper 38 vorzusehen, der jedoch im Vergleich zu einem Multilayer-Aufbau über einen wesentlich kostengünstigeren monolithischen Aufbau verfügt. Dabei ist das Piezo-Material zweckmäßigerweise mit der für einen aktiven Betrieb üblicherweise erforderlichen Polarisation versehen, um tatsächlich das gleiche Temperaturverhalten wie der Piezo-Schichtkörper 6 zu erzielen. Allerdings wird der zweite Piezo-Körper 38 nicht aktiviert, er dient lediglich zur Anpassung bzw. zum Erhalt des symmetrischen Aufbaus.

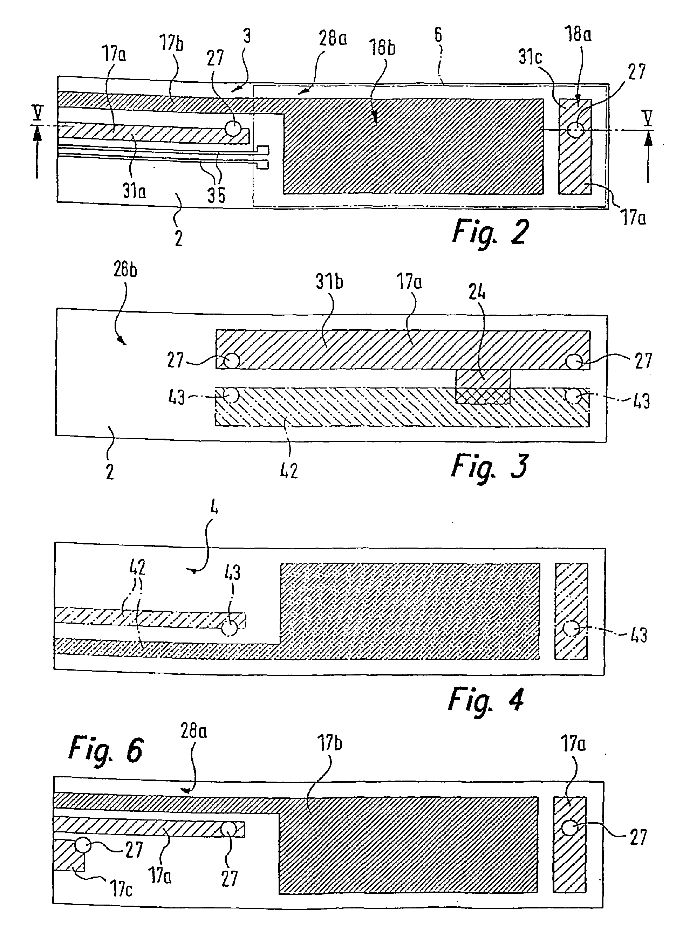

Gleichwohl wäre es selbstverständlich möglich, auf Basis des erfinderischen Gedankens einen Trimorph-Biegewandler zu schaffen, der über zwei Piezo-Körper 5, 38 verfügt, die beide aktivierbar sind, um den Piezo-Biegewandler 1 aktiv nicht nur nach einer, sondern nach zwei einander entgegengesetzten Seiten auslenken zu können. Dabei ist es empfehlenswert, auch den zweiten Piezo-Körper 38 als Piezo-Schichtkörper auszuführen. Der Tragkörper 2 kann dann, wie in Fig. 1 und 4 strichpunktiert angedeutet, mit weiteren elektrischen Leitern 42 und Durchkontaktierungen 43 - vergleichbar den oben im Detail geschilderten ersten und zweiten elektrischen Leitern 17a, 17b und Durchkontaktierungen 27 - ausgestattet sein, die die Ansteuerung des an der zweiten Tragfläche 4 plazierten zweiten Piezo-Körpers 38 gestatten. Werden die vorhandenen Elektronik- und/oder Sensorikkomponenten in einem Piezo-Schichtkörper 6 oder in dem Übergangsbereich zwischen einem Piezo-Körper und dem Tragkörper 2 plaziert, läßt sich der Piezo-Biegewandler 1 ohne weiteres auch mit einem Einschicht-Tragkörper 2 ausstatten.

Der Piezo-Biegewandler läßt sich vorteilhaft als Stellglied in einem zur Steuerung von Fluidströmen dienenden Ventil verwenden. In Fig. 5 ist strichpunktiert ein Ausschnitt des Gehäuses 44 eines Pneumatikventils angedeutet, das über eine Fluidkanalmündung 45 verfügt, die durch Aktivieren bzw. Deaktivieren des Piezo-Biegewandlers 1 durch diesen wahlweise verschlossen oder freigegeben wird.

## Patentansprüche

1. Piezo-Biegewandler, mit einem länglichen Tragkörper (2), der an wenigstens einer Längsseite mit einem mehrere Schichten aus Piezo-Material (7) und dazwischenliegende Elektroden (9, 10) aufweisenden Piezo-Schichtkörper (6) bestückt ist, **dadurch gekennzeichnet, daß** im Innern des Tragkörpers (2) und/oder zwischen dem Tragkörper (2) und dem Piezo-Schichtkörper (6) und/oder zwischen benachbarten Piezo-Materialschichten (7) des Piezo-Schichtkörpers (6) mindestens eine Komponente (24, 24a; 32, 32a) einer für den Betrieb des Piezo-Biegewandlers (1) verwendeten Elektronik (23) und/oder Sensorik (33) untergebracht ist.

2. Piezo-Biegewandler nach Anspruch 1, **dadurch gekennzeichnet, dass** mindestens eine Elektronikkomponente (24, 24a) zu einer Spannungswandlerschaltung, zu einer Strombegrenzungsschaltung oder zu einer Lade-/Entladeschaltung gehört oder eine solche bildet.

3. Piezo-Biegewandler nach Anspruch 1 oder 2, **dadurch gekennzeichnet, dass** mindestens eine Elektronikkomponente (24, 24a) zu einer Ansteuerelektronik für den Piezo-Biegewandler gehört oder eine solche bildet.

4. Piezo-Biegewandler nach einem der Ansprüche 1 bis 3, **dadurch gekennzeichnet, dass** mindestens eine Sensorikkomponente (32, 32a) von einem zur Erfassung der Auslenkung des Biegewandlers dienenden Auslenkungssensor gebildet ist, insbesondere von einem Dehnmeßstreifen oder von induktiven Aufnehmern und/oder Spulen.

5. Piezo-Biegewandler nach einem der Ansprüche 1 bis 4, **dadurch gekennzeichnet, dass** mindestens eine Sensorikkomponente (32, 32a) von einem Kraftsensor, einem Beschleunigungssensor und/oder einem Temperatursensor gebildet ist.

6. Piezo-Biegewandler nach einem der Ansprüche 1 bis 5, **dadurch gekennzeichnet, dass** mindestens eine Elektronik- und/oder Sensorikkomponente (24, 24a; 32, 32a) in sogenannter Dünnschichttechnik und/oder als SMD-Bauelement (SMD = Surface Mounted Device) und/oder als Nackt-Chip ausgebildet ist.

7. Piezo-Biegewandler nach einem der Ansprüche 1 bis 6, **dadurch gekennzeichnet, dass** der Tragkörper (2) als Mehrschichtkörper mit mindestens zwei aufeinanderliegenden Tragkörperschichten (25, 26) ausgebildet ist.

8. Piezo-Biegewandler nach Anspruch 7, **dadurch gekennzeichnet, dass** die Schichtebenen der Tragkörperschichten und der Piezo-Materialschichten parallel zueinander verlaufen.

9. Piezo-Biegewandler nach Anspruch 7 oder 8, **dadurch gekennzeichnet, dass** mindestens eine im Innern des Tragkörpers (2) befindliche Elektronik- und/oder Sensorikkomponente (24, 32) zwischen zwei benachbarten Tragkörperschichten (25, 26) angeordnet ist.

10. Piezo-Biegewandler nach einem der Ansprüche 1 bis 9, **dadurch gekennzeichnet, dass** der Tragkörper (2) mit in unterschiedlichen Bestückungsebenen (28) angeordneten elektrischen Leitern (17a, 17b, 17c, 42) versehen ist, die durch eine oder mehrere, quer zu den Bestückungsebenen (28) verlaufende Durchkontaktierungen (27, 43) elektrisch miteinander kontaktiert sind.

11. Piezo-Biegewandler nach Anspruch 10 in Verbindung mit einem der Ansprüche 7 bis 9, **dadurch gekennzeichnet, dass** mindestens eine Durchkontaktierung (27, 43) vorhanden ist, die lediglich eine Tragkörperschicht durchsetzt, um beidseits derselben vorhandene elektrische Leiter miteinander zu verschalten.

12. Piezo-Biegewandler nach einem der Ansprüche 1 bis 11, **dadurch gekennzeichnet, dass** der Piezo-Schichtkörper (6) die ihm zugewandte Tragfläche (3) des Tragkörpers (2) nur teilweise belegt, wobei ein freier Abschnitt der Tragfläche (3) mit mindestens einer weiteren Elektronikkomponente (36) bestückt ist.

13. Piezo-Biegewandler nach einem der Ansprüche 1 bis 12, **dadurch gekennzeichnet, dass** die Schichtdicke der einzelnen Piezo-Materialschichten (7) maximal 25 µm beträgt, vorzugsweise im Bereich zwischen 14 µm und 20 µm liegt und insbesondere 17 µm beträgt.

14. Piezo-Biegewandler nach einem der Ansprüche 1 bis 13, **dadurch gekennzeichnet, dass** die Schichtdicke der Piezo-Materialschichten (7) derart bemessen ist, dass die zur Betätigung des Piezo-Biegewandlers erforderliche Ansteuerspannung maximal 60 Volt beträgt.

15. Piezo-Biegewandler nach einem der Ansprüche 1 bis 14, **dadurch gekennzeichnet, dass** der Tragkörper (2) auf der dem Piezo-Schichtkörper (6) entgegengesetzten Längsseite einen monolithischen Piezo-Körper (38) trägt.

16. Piezo-Biegewandler nach einem der Ansprüche 1 bis 15, **dadurch gekennzeichnet, dass** der Tragkörper (2) auf der dem Piezo-Schichtkörper (6) entgegengesetzten Längsseite mit einem Anpaßkörper (37) aus einem Material mit im wesentlichen gleichen thermischen Ausdehnungskoeffizienten wie das Piezo-Material des Piezo-Schichtkörpers (6) bestückt ist.

17. Piezo-Biegewandler nach einem der Ansprüche 1 bis 14, **dadurch gekennzeichnet, dass** der Tragkörper (2) auf der dem Piezo-Schichtkörper (6) entgegengesetzten Längsseite mit einem weiteren Piezo-Schichtkörper bestückt ist.

18. Verwendung eines Piezo-Biegewandlers nach einem der Ansprüche 1 bis 17 als Stellglied eines Ventils insbesondere auf dem Pneumatiksektor.

## Claims

1. Piezoelectric bending transducer with an oblong supporting body (2) fitted with a piezoelectric layered body (6) comprising a plurality of layers of a piezoelectric material (7) and interposed electrodes (9, 10) on at least one of its sides, **characterised in that** at least one component (24, 24a; 32, 32a) of an electronic system (23) and/or a sensor system (33) used for the operation of the piezoelectric bending transducer (1) is accommodated within the supporting body (2) and/or between the supporting body (2) and the piezoelectric layered body (6) and/or between adjacent piezoelectric material layers (7) of the piezoelectric layered body (6).

2. Piezoelectric bending transducer according to claim 1, **characterised in that** at least one electronic component (24, 24a) forms part of or represents a voltage transformer circuit and/or a current limiting circuit and/or a charging/discharging circuit.

3. Piezoelectric bending transducer according to claim 1 or 2, **characterised in that** at least one electronic component (24, 24a) forms part of or represents an electronic drive unit for the piezoelectric bending transducer.

4. Piezoelectric bending transducer according to any of claims 1 to 3, **characterised in that** at least one sensor component (32, 32a) is represented by a deflection sensor for the detection of the deflection of the bending transducer, in particular by a strain gauge or by inductive sensors and/or coils.

5. Piezoelectric bending transducer according to any of claims 1 to 4, **characterised in that** at least one sensor component (32, 32a) is represented by a force sensor, an acceleration sensor and/or a temperature sensor.

6. Piezoelectric bending transducer according to any of claims 1 to 5, **characterised in that** at least one electronic and/or sensor component (24, 24a; 32, 32a) is designed in so-called thin-film technology and/or as SMD element (SMD = surface mounted device) and/or as a bare chip.

7. Piezoelectric bending transducer according to any of claims 1 to 6, **characterised in that** the supporting body (2) is designed as a multi-layer body with at least two supporting body layers (25, 26) placed on top of one another.

8. Piezoelectric bending transducer according to claim 7, **characterised in that** the planes of the supporting body layers and the piezoelectric material layers are parallel to one another.

9. Piezoelectric bending transducer according to claim 7 or 8, **characterised in that** at least one electronic and/or sensor component (24, 32) located within the supporting body (2) is placed between two adjacent supporting body layers (25, 26).

10. Piezoelectric bending transducer according to any of claims 1 to 9, **characterised in that** the supporting body (2) is provided with electric conductors (17a, 17b, 17c, 42) located in different mounting planes (28), which are in electric contact with one another through one or more plated-through holes (27, 43) extending at right angles to the mounting planes (28).

11. Piezoelectric bending transducer according to claim 10 in combination with any of claims 7 to 9, **characterised in that** at least one plated-through hole (27, 43) passing through only one supporting body layer is provided to interconnect electric conductors located on both sides thereof.

12. Piezoelectric bending transducer according to any of claims 1 to 11, **characterised in that** the piezoelectric layered body (6) covers only part of the adjacent supporting surface (3) of the supporting body (2), at least one further electronic component (36) being mounted on a free section of the supporting surface (3).

13. Piezoelectric bending transducer according to any of claims 1 to 12, **characterised in that** the maximum layer thickness of the individual piezoelectric material layers (7) is 25 µm, lying preferably in a range between 14 µm and 20 µm and being in particular 17 µm.

14. Piezoelectric bending transducer according to any of claims 1 to 13, **characterised in that** the layer thickness of the piezoelectric material layers (7) is so dimensioned that a maximum drive voltage of 60 Volts is required to actuate the piezoelectric bending transducer.

15. Piezoelectric bending transducer according to any of claims 1 to 14, **characterised in that** the supporting body (2) supports a monolithic piezoelectric body (38) on the side opposite the piezoelectric layered body (6).

16. Piezoelectric bending transducer according to any of claims 1 to 15, **characterised in that** the supporting body is fitted with an adapter body (37) of a material with a coefficient of thermal expansion substantially equal to that of the piezoelectric material of the piezoelectric layered body (6) on the side opposite the piezoelectric layered body (6).

17. Piezoelectric bending transducer according to any of claims 1 to 14, **characterised in that** the supporting body (2) is fitted with a further piezoelectric layered body on the side opposite the piezoelectric layered body (6).

18. Application of a piezoelectric bending transducer according to any of claims 1 to 17 as an actuator of a valve, in particular in pneumatic engineering.

## Revendications

1. Convertisseur à flexion piézo-électrique, comportant un corps de support (2) allongé qui est équipé, sur au moins un côté longitudinal, d'un corps piézo-électrique à couches (6) présentant plusieurs couches d'un matériau piézo-électrique (7) et des électrodes (9, 10) intercalées, **caractérisé en ce qu'**à l'intérieur du corps de support (2) et/ou entre le corps de support (2) et le corps piézo-électrique à couches (6) et/ou entre des couches voisines de matériau piézo-électrique (7) du corps piézo-électrique à couches (6), est logé au moins un composant (24, 24a ; 32, 32a) d'une électronique (23) et/ou d'un dispositif de détection (33) utilisé pour le fonctionnement du convertisseur à flexion piézo-électrique (1).

2. Convertisseur à flexion piézo-électrique selon la revendication 1, **caractérisé en ce qu'**au moins un composant électronique (24, 24a) fait partie d'un circuit de transformation de tension, d'un circuit de limitation de courant ou d'un circuit de charge/décharge, ou forme un tel circuit.

3. Convertisseur à flexion piézo-électrique selon la revendication 1 ou 2, **caractérisé en ce qu'**au moins un composant électronique (24, 24a) fait partie d'une électronique de commande du convertisseur à flexion piézo-électrique, ou forme celle-ci.

4. Convertisseur à flexion piézo-électrique selon l'une des revendications 1 à 3, **caractérisé en ce qu'**au moins un composant de détection (32, 32a) est formé par un capteur de déviation servant à détecter la déviation du convertisseur à flexion, en particulier par une jauge d'allongement ou par des capteurs inductifs et/ou des bobines.

5. Convertisseur à flexion piézo-électrique selon l'une des revendications 1 à 4, **caractérisé en ce qu'**au moins un composant de détection (32, 32a) est formé par un capteur de force, un capteur d'accélération et/ou une sonde de température.

6. Convertisseur à flexion piézo-électrique selon l'une des revendications 1 à 5, **caractérisé en ce qu'**au moins un composant électronique et/ou composant de détection (24, 24a ; 32, 32a) est réalisé dans une technique dite à couches minces et/ou en tant que composant SMD (SMD = Surface Mounted Device) et/ou comme puce nue.

7. Convertisseur à flexion piézo-électrique selon l'une des revendications 1 à 6, **caractérisé en ce que** le corps de support (2) est réalisé sous la forme d'un corps à plusieurs couches avec au moins deux couches de corps de support (25, 26) superposées.

8. Convertisseur à flexion piézo-électrique selon la revendication 7, **caractérisé en ce que** les plans des couches du corps de support et des couches du matériau piézo-électrique s'étendent parallèlement les uns aux autres.

9. Convertisseur à flexion piézo-électrique selon la revendication 7 ou 8, **caractérisé en ce qu'**au moins un composant électronique et/ou de détection (24, 32) se trouvant à l'intérieur du corps de support (2) est disposé entre deux couches voisines (25, 26) du corps de support.

10. Convertisseur à flexion piézo-électrique selon l'une des revendications 1 à 9, **caractérisé en ce que** le corps de support (2) est pourvu de lignes électriques (17a, 17b, 17c, 42) disposées dans des plans d'équipement (28) différents, lesquels sont mis électriquement en contact entre eux par une ou plusieurs traversées métallisées (27, 43) s'étendant transversalement aux plans d'équipement (28).

11. Convertisseur à flexion piézo-électrique selon la revendication 10 en combinaison avec l'une des revendications 7 à 9, **caractérisé en ce qu'**il est prévu au moins une traversée métallise (27, 43) qui traverse uniquement une couche du corps de support, pour relier entre eux des conducteurs électriques se trouvant des deux côtés de celle-ci.

12. Convertisseur à flexion piézo-électrique selon l'une des revendications 1 à 11, **caractérisé en ce que** le corps piézo-électrique à couches (6) n'occupe que partiellement la surface de support (3) du corps de support (2), qui est tournée vers lui, une partie libre de la surface de support (3) étant équipée d'au moins un autre composant électronique (36).

13. Convertisseur à flexion piézo-électrique selon l'une des revendications 1 à 12, **caractérisé en ce que** l'épaisseur des différentes couches de matériau piézo-électrique (7) est au maximum de 25 µm, de préférence comprise entre 14 µm et 20 µm, et en particulier égale à 17 µm.

14. Convertisseur à flexion piézo-électrique selon l'une des revendications 1 à 13, **caractérisé en ce que** l'épaisseur des couches de matériau piézo-électrique (7) est dimensionnée de façon telle que la tension de commande, nécessaire à l'actionnement du convertisseur à flexion piézo-électrique, soit au maximum de 60 volts.

15. Convertisseur à flexion piézo-électrique selon l'une des revendications 1 à 14, **caractérisé en ce que** le corps de support (2) porte, sur le côté longitudinal opposé au corps piézo-électrique à couches (6), un corps piézo-électrique (38) monolithique.

16. Convertisseur à flexion piézo-électrique selon l'une des revendications 1 à 15, **caractérisé en ce que** le corps de support (2) est équipé, sur le côté longitudinal opposé au corps piézo-électrique à couches (6), d'un corps d'adaptation (37) en un matériau qui présente sensiblement les mêmes coefficients de dilatation thermique que le matériau piézo-électrique du corps piézo-électrique à couches (6).

17. Convertisseur à flexion piézo-électrique selon l'une des revendications 1 à 14, **caractérisé en ce que** le corps de support (2) est équipé, sur le côté longitudinal opposé au corps piézo-électrique à couches (6), d'un autre corps piézo-électrique à couches.

18. Utilisation d'un convertisseur à flexion piézo-électrique selon l'une des revendications 1 à 17 comme organe de réglage d'une soupape, en particulier dans le domaine pneumatique.
